# DEMANDE DE BREVET EUROPEEN

(11) **EP 2 822 027 A2**
(43) Date de publication de la demande: **07.01.2015**
(21) Numéro de dépôt: 14175540.5
(22) Date de dépôt: 03.07.2014
(51) Int. Cl.: H01L 21/28, H01L 29/423, H01L 29/792, H01L 21/336, H01L 29/66

(54) **Procédé de fabrication d'une cellule mémoire électronique à double grille et cellule mémoire associée**

(30) Priorité: 05.07.2013 FR 1356619
(71) Demandeur: COMMISSARIAT A L'ENERGIE ATOMIQUE ET AUX ENERGIES ALTERNATIVES, 75015 Paris (FR)
(72) Inventeur: Charpin-Nicolle, Christelle, 38120 FONTANIL-CORNILLON (FR)
(74) Mandataire: Lebkiri, Alexandre

(57) **Abrégé**

La présente invention concerne un procédé de fabrication d'une cellule mémoire électronique à double grille, ladite cellule mémoire électronique comportant :
- un substrat ;
- une première structure de grille déposée sur le substrat, la première structure de grille présentant au moins un flanc latéral ;
- un empilement comprenant plusieurs couches et dont au moins une desdites couches est apte à stocker des charges électriques, ledit empilement recouvrant au moins le flanc latéral de la première structure de grille et une partie du substrat ;
- une deuxième structure de grille isolée de la première structure de grille et du substrat par l'empilement.

La deuxième structure de grille comporte par ailleurs :
- une première partie formée d'un premier matériau de grille ;
- une deuxième partie formée d'un deuxième matériau de grille, ledit premier matériau de grille pouvant être gravé sélectivement par rapport au dit deuxième matériau de grille et ledit deuxième matériau de grille pouvant être gravé sélectivement par rapport au dit premier matériau de grille ;
- une première zone de siliciuration s'étendant sur ladite première partie de la deuxième structure de grille ;
- une deuxième zone de siliciuration s'étendant sur ladite deuxième partie de la deuxième structure de grille.

## Description

### DOMAINE TECHNIQUE DE l'INVENTION

La présente invention concerne le domaine des procédés de fabrication des cellules mémoires électroniques non volatiles à double grille, et plus particulièrement celui des procédés de fabrication des mémoires Flash à double grille (grille flottante de mémorisation et grille de sélection) trouvant une application particulièrement intéressante dans le domaine de l'électronique embarquée. L'invention concerne également le domaine des cellules mémoires obtenues par ces procédés.

### ARRIERE PLAN TECHNOLOGIQUE DE L'INVENTION

Il existe plusieurs types de mémoires non-volatiles, c'est-à-dire des mémoires conservant une information mémorisée en l'absence d'alimentation électrique, pouvant être écrites et/ou effacées électriquement :
- les EPROMs (« Erasable Programmable Read Only Memories » en anglais, ou mémoires mortes effaçables et programmables), dont le contenu peut être écrit électriquement, mais qui doivent être soumises à un rayonnement UV pour effacer les informations mémorisées ;
- les EEPROMs (« Electrically Erasable Programmable ROMs » en anglais, ou mémoires mortes effaçables et programmables électriquement), dont le contenu peut être écrit et effacé électriquement, mais qui requièrent, pour leur réalisation, des surfaces de semi-conducteur plus importantes que les mémoires de type EPROM, et qui sont donc plus coûteuses à réaliser.

Il existe également des mémoires non volatiles, appelées mémoires Flash, qui ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en matière de densité d'intégration et l'avantage des mémoires EEPROMs en matière d'effacement électrique.

De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, clés USB, etc. De plus, les mémoires Flash ne possèdent pas d'éléments mécaniques, ce qui leur confère une assez grande résistance aux chocs.

La plupart des mémoires Flash sont du type « stand-alone » et présentent de grandes capacités de stockage, généralement supérieures à 1 Gb, et sont dédiées aux applications de stockage de masse.

Cependant, il existe également des mémoires Flash dites embarquées (« embedded memories ») dont la réalisation est intégrée dans un procédé de type CMOS et qui trouvent un intérêt croissant, par exemple dans les domaines de l'automobile ou des microcontrôleurs, pour le stockage de données ou de codes. Ces mémoires Flash embarquées sont réalisées sur une puce qui comporte également des dispositifs CMOS destinés à réaliser des fonctions logiques autres qu'une mémorisation de données. Ces mémoires Flash embarquées sont généralement réalisées pour des capacités de stockage plus faibles que celles des mémoires de type « stand-alone », leurs capacités pouvant varier généralement de quelques bits à quelques Mb. Les caractéristiques visées des mémoires Flash embarquées sont un faible coût de réalisation, une excellente fiabilité (notamment à haute température), une faible consommation électrique, ou encore une vitesse de programmation élevée, ces caractéristiques étant fonction de l'application à laquelle elles sont destinées.

La plupart des mémoires Flash comportent une structure de type transistor MOS (grille, source, drain et canal) comportant un site de stockage de charges électriques, appelé grille flottante, formé par exemple d'une couche de polysilicium disposée entre deux couches d'oxyde, et disposé entre le matériau électriquement conducteur de grille et le canal du transistor. Une mémorisation est réalisée en appliquant sur le matériau conducteur une tension supérieure à la tension de seuil, par exemple comprise entre 15 V et 20 V, qui permet de stocker l'information sous forme de charges piégées dans la grille flottante.

Cependant, de telles mémoires présentent des inconvénients limitant la réduction de leurs dimensions. En effet, une réduction de l'épaisseur de l'oxyde tunnel (oxyde disposé entre le canal et la couche de polysilicium) entraîne une augmentation du SILC (« Stress Induced Leakage Current »). Or, l'utilisation prolongée d'une telle mémoire (répétition de cycles écriture - effacement) génère des défauts dans l'oxyde tunnel qui vont assister la conduction de charges et dégrader la rétention des charges dans la grille flottante, ce qui pose des problèmes dans le cas d'un SILC important. Dans la pratique, il est donc difficile de réduire l'épaisseur de l'oxyde tunnel de ces mémoires à moins de 8 nm sans que le SILC ne devienne un phénomène critique pour la mémorisation. De plus, en réduisant les dimensions d'une telle cellule mémoire, le couplage parasite entre les grilles flottantes de deux cellules adjacentes d'une même mémoire devient important et peut donc dégrader la fiabilité de la mémoire.

Pour ces raisons, des mémoires de type MONOS (Métal Oxyde Nitrure Oxyde Silicium), également appelées mémoires NROM, ont été proposées pour remplacer les mémoires à grille flottante en polysilicium. Le document US5768192 décrit de telles mémoires dans lesquelles les charges électriques sont stockées dans des pièges formés dans une grille flottante composée de nitrure et disposée entre deux couches d'oxyde. Dans une telle couche de nitrure, les pièges sont isolés les uns des autres. Ainsi, un électron stocké dans un des pièges reste localisé physiquement dans ce piège, ce qui rend ces mémoires beaucoup plus « résistantes » aux défauts dans l'oxyde tunnel, et donc moins impactées par une augmentation du SILC. En effet, en présence d'un défaut dans l'oxyde tunnel, la couche de mémorisation, c'est-à-dire la couche de nitrure, perd uniquement les électrons situés dans l'entourage proche du défaut, les autres électrons piégés n'étant pas affectés par ce défaut. Ces mémoires disposent donc d'une meilleure fiabilité. Il est ainsi possible d'avoir un oxyde tunnel d'épaisseur inférieure à environ 8 nm, et donc de réduire les tensions de programmation nécessaires. De plus, du fait de la faible épaisseur du nitrure pour former la couche de mémorisation, le couplage entre deux cellules mémoires adjacentes est fortement réduit par rapport à des cellules à grille flottante en polysilicium. Enfin, la structure d'une mémoire de type NROM est également adaptée pour réaliser des mémoires embarquées en raison de la simplicité du procédé d'intégration de ces mémoires.

Le document de S. Kianian et al., « A novel 3 volts-only, small sector erase, high density flash E2PROM » (Technical Digest of VLSI Technology, 1994, p.71) décrit un autre type de mémoire, appelée mémoire « split-gate », qui comporte au sein d'une même cellule mémoire un transistor de mémorisation et un transistor de sélection (ou transistor de commande) formés sur une unique zone active. Une telle cellule mémoire à double grille est généralement programmée par injection de porteurs par la source (« source side injection » en anglais), mécanisme qui requiert justement la présence d'un transistor de sélection accolé au transistor de mémorisation, et qui permet d'augmenter la vitesse de programmation tout en réduisant la consommation par rapport à une mémoire de type NROM.

Afin de bénéficier des avantages de chaque structure, split-gate et NROM, le document US2004/207025A1 propose un autre type de mémoire à double grille combinant la structure d'une mémoire de type NROM avec une architecture split-gate. Une des difficultés pour réaliser ces mémoires concerne le contrôle de la position des grilles (grille du transistor de commande et grille du transistor de mémorisation) l'une par rapport à l'autre.

En effet, ces grilles sont réalisées par deux photolithographies successives, le désalignement de la seconde grille par rapport à la première grille fixant la longueur de la seconde grille. Un mauvais contrôle des positions relatives des deux grilles se traduit donc par un mauvais contrôle des caractéristiques électriques du second transistor, et donc potentiellement de mauvaises performances de la mémoire. Par conséquent, un contrôle très précis de la position des grilles est nécessaire lors de la réalisation de ce type de mémoire.

Afin de s'affranchir de cette contrainte d'alignement, le document US7130223B2 propose de réaliser une mémoire à double grille combinant la structure d'une mémoire de type NROM avec une architecture split-gate et dans laquelle la grille du transistor de mémorisation, c'est-à-dire la grille comportant la couche de mémorisation de données, est réalisée sous la forme d'un espaceur latéral de la grille du transistor de commande, disposé contre un des deux flancs latéraux de la grille du transistor de commande. Une telle structure permet de contrôler précisément la position et la dimension de la grille du transistor de mémorisation par rapport à la grille du transistor de commande car, du fait que la grille du transistor de mémorisation soit réalisée sous la forme d'un espaceur latéral, celle-ci est donc auto-alignée par rapport à la grille du transistor de commande.

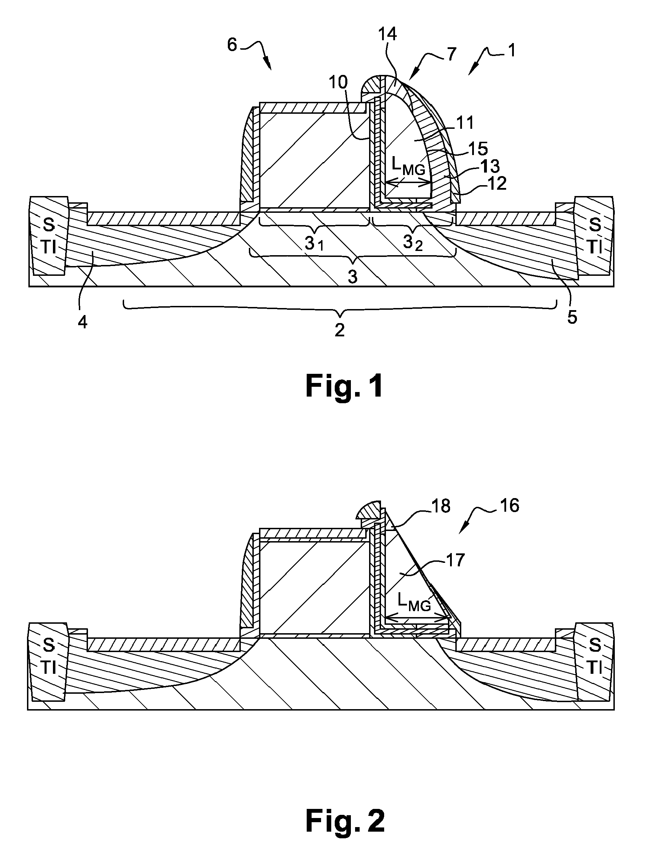

Une telle structure est illustrée par la figure 1 qui représente schématiquement une mémoire 1 à double grille combinant la structure d'une mémoire de type NROM avec une architecture split-gate dans laquelle la grille du transistor de mémorisation est réalisée sous la forme d'un espaceur latéral de la grille du transistor de commande. La mémoire 1 comporte une zone active 2 réalisée dans un matériau semi-conducteur et comportant un canal 3 disposé entre une région d'extension de drain 4 et une région d'extension de source 5. La mémoire 1 comporte en outre une grille de transistor de sélection 6 surmontant une première partie 3₁ du canal 3 et une grille de transistor mémoire 7 disposée contre le flanc latéral de la grille du transistor de sélection 6.

Cette grille du transistor mémoire 7 comporte notamment :
- un empilement 10 de couches dont au moins une desdites couches est apte à stocker des charges électriques. La couche apte à stocker des charges électriques dudit empilement de couches peut être disposée entre deux couches de matériau diélectrique dudit empilement. L'empilement 10 peut être par exemple de type ONO (oxyde-nitrure-oxyde) ;
- une zone conductrice 11 de grille du transistor mémoire en polysilicium présentant un flanc latéral 15 sensiblement arrondi ;
- des couches 12, 13 d'espaceurs fins localisées sur la partie arrondie de la zone conductrice 11, par exemple en oxyde à haute température (« High Thermal Oxide » en anglais) HTO (couche 13) et en nitrure Si₃N₄ (couche 12). On retrouve ces couches d'espaceurs fins sur la partie opposée du transistor de sélection.

L'empilement 10 permet de contribuer à former la grille du transistor mémoire 7 et de contribuer à isoler l'une de l'autre la grille 6 du transistor de sélection et la grille 7 du transistor mémoire.

Toutefois, avec une telle structure, il est très difficile de réaliser ensuite une reprise de contact électrique sur la grille du transistor mémoire 7 compte tenu des faibles dimensions de cette grille en forme d'espaceur latéral. Cette reprise de contact est par exemple illustrée par la zone de siliciuration 14 située en haut du flanc latéral arrondi 15. On constate que la zone permettant la siliciuration est relativement réduite. Cette difficulté est encore accentuée du fait que les flancs obtenus par les procédés standards sont plutôt de forme triangulaire ; il est en effet très difficile d'obtenir par gravure directe une forme arrondie permettant d'obtenir une surface de siliciuration suffisante. Une telle architecture 16 est illustrée en figure 2. La mémoire 16 est identique à la mémoire 1 mais présente une zone conductrice 17 de forme triangulaire sur laquelle la zone de siliciuration 18 est encore plus limitée que dans le cas de la figure 1.

En outre, l'article « Scalability of split-gate charge memories down to 20nm for low-power embedded memories » (Masoero et al. - Electron Devices Meeting (IEDM) - 2011) a démontré que la diminution de la longueur de grille mémoire L_{MG} (i.e. la longueur de la zone conductrice 17 de grille du transistor mémoire la plus proche du canal 3 et mesurée suivant la longueur du canal 3 - cf. figure 1) permet d'améliorer les performances électriques de la mémoire telles que la fenêtre de programmation ou l'énergie consommée. On conçoit aisément qu'une telle diminution de la longueur de grille rend encore plus délicate la réalisation d'une zone de contact importante au niveau de la grille du transistor mémoire.

### DESCRIPTION GENERALE DE L'INVENTION

Le procédé selon l'invention vise à remédier aux inconvénients de l'état de la technique en proposant un procédé de fabrication d'une cellule mémoire électronique de type NROM avec une architecture split-gate permettant à la fois d'obtenir une surface de reprise de contact (i.e. zone de siliciuration) satisfaisante tout en améliorant les performances électriques de ladite cellule mémoire.

L'invention concerne donc essentiellement un procédé de fabrication d'une cellule mémoire électronique comportant :
- un substrat ;
- une première structure de grille déposée sur le substrat ;
- un empilement comprenant plusieurs couches et dont au moins une desdites couches est apte à stocker des charges électriques, ledit empilement recouvrant au moins un flanc latéral de la première structure de grille et une partie du substrat ;
- une deuxième structure de grille isolée de la première structure de grille et du substrat par l'empilement ;
la formation de la deuxième structure de grille comportant les étapes suivantes :
- dépôt d'une couche d'un premier matériau de la deuxième structure de grille, dit « premier dépôt », au moins sur la zone recouverte par l'empilement ;
- dépôt d'une couche d'un deuxième matériau de la deuxième structure de grille, dit « deuxième dépôt », au moins sur la zone recouverte par la couche de premier matériau, ledit deuxième matériau pouvant être gravé sélectivement par rapport au dit premier matériau et ledit premier matériau pouvant être gravé sélectivement par rapport au dit deuxième matériau ;
- gravure de l'épaisseur de la couche de deuxième matériau, dite « première gravure », sélectivement par rapport au premier matériau de façon à conserver la partie du deuxième matériau recouvrant latéralement le premier matériau ;
- gravure de l'épaisseur de la couche de premier matériau, dite « deuxième gravure », sélectivement par rapport au deuxième matériau de façon à conserver la partie du premier matériau recouvrant latéralement l'empilement, la deuxième structure de grille comportant ainsi ladite partie du premier matériau recouvrant latéralement l'empilement, dite « première région » et au moins une partie de ladite partie du deuxième matériau recouvrant latéralement le premier matériau, dite « deuxième région » ;
- siliciuration d'une première zone s'étendant sur ladite première région de la deuxième structure de grille, et d'une deuxième zone s'étendant sur ladite deuxième région de la deuxième structure de grille.

On entend par « deuxième matériau pouvant être gravé sélectivement par rapport au dit premier matériau » qu'il existe une première méthode de gravure qui affecte principalement ou exclusivement le deuxième matériau et qui affecte moins ou n'affecte pas le premier matériau. On entend par « premier matériau pouvant être gravé sélectivement par rapport au dit deuxième matériau » qu'il existe une deuxième méthode de gravure qui affecte principalement ou exclusivement le premier matériau et qui affecte moins ou n'affecte pas le deuxième matériau.
D'une manière générale, on entend par « gravure de l'épaisseur d'une couche d'un matériau A sélectivement par rapport à un matériau B » que ladite gravure affecte principalement ou exclusivement ledit matériau A et affecte moins ou n'affecte pas ledit matériau B.

Durant la deuxième gravure, le deuxième matériau protège le premier matériau et contribue à l'obtention d'une surface et d'un volume de siliciuration de la deuxième structure de grille plus importants que dans l'état de la technique, permettant ainsi une meilleure reprise de contacts que dans l'état de la technique. Le deuxième matériau, en protégeant le premier matériau auquel il est accolé, contribue également à l'obtention d'un flanc latéral de la deuxième structure de grille sensiblement perpendiculaire au plan du substrat. Un tel flanc latéral sensiblement perpendiculaire au plan du substrat permet, par rapport à l'état de la technique, de mieux contrôler la longueur de la deuxième structure de grille et donc de mieux contrôler les performances électriques de la mémoire telles que la fenêtre de programmation ou l'énergie consommée. Il permet également d'assurer une épaisseur minimum du premier matériau après gravure et ainsi de mieux contrôler l'implantation, c'est-à-dire la largeur et la profondeur d'implantation.

La première gravure est avantageusement anisotrope afin de conserver la partie du deuxième matériau recouvrant latéralement le premier matériau. De même, la deuxième gravure est avantageusement anisotrope afin de conserver la partie du premier matériau recouvrant latéralement l'empilement.

Outre les caractéristiques principales mentionnées dans le paragraphe précédent, le procédé de fabrication d'une cellule mémoire selon l'invention peut présenter une ou plusieurs caractéristiques complémentaires parmi les suivantes, considérées individuellement ou selon les combinaisons techniquement possibles.

Le premier matériau résiduel et le deuxième matériau résiduel à l'issue de l'étape de deuxième gravure présentent chacun une surface supérieure. Le substrat s'étendant sur un plan de référence, on entend par « surface supérieure » d'un matériau la surface dudit matériau la plus distante dudit plan de référence du substrat.
A l'issue de l'étape de deuxième gravure, la surface supérieure du premier matériau et la surface supérieure du deuxième matériau sont généralement non-alignées et présentent une différence de marche. On définit dans ce document la différence de marche entre deux surfaces comme étant la différence de hauteur entre ces deux surfaces, la hauteur d'une surface étant définie par la distance entre cette surface et la surface du substrat suivant une direction normale au plan de référence du substrat. Suivant les paramètres de gravure choisis pour cette étape de deuxième gravure, la différence de marche peut être plus ou moins importante : si le deuxième matériau n'est pas du tout gravé, la différence de marche est maximale.

Le procédé peut avantageusement comporter, postérieurement à l'étape de deuxième gravure, une étape de troisième gravure du deuxième matériau sélectivement par rapport au premier matériau, de telle sorte qu'à l'issue de cette étape de troisième gravure la face supérieure du deuxième matériau et la face supérieure du premier matériau sont alignées. La face supérieure du premier matériau et la face supérieure du deuxième matériau forment alors une surface continue, sans différence de marche. On contribue ainsi à l'obtention d'une surface et d'un volume de siliciuration de la deuxième structure de grille maximums, permettant une meilleure reprise de contacts ultérieure.

Avant le dépôt du deuxième matériau, le premier matériau est avantageusement préalablement nettoyé avec de l'acide fluorhydrique HF. On entend par « le premier matériau est avantageusement préalablement nettoyé avec de l'acide fluorhydrique HF » le fait que le premier matériau est mis en contact avec une solution d'acide fluorhydrique afin d'éliminer les impuretés potentiellement présentes sur le premier matériau et assurer un meilleur état de surface.

Lors de l'étape de premier dépôt, le dépôt du premier matériau est avantageusement un dépôt conforme. De même, lors de l'étape de deuxième dépôt, le dépôt du deuxième matériau est avantageusement un dépôt conforme. Dans ce document, on entend par « dépôt conforme » un dépôt recouvrant de manière constante le relief sur lequel il est déposé. Ainsi, on contribue à mieux contrôler le dimensionnement et donc les propriétés de la cellule mémoire électronique obtenue grâce au procédé selon l'invention. Le dépôt du premier matériau peut ainsi avantageusement être un dépôt chimique en phase vapeur réalisé à pression sous-atmosphérique.

La technique de gravure utilisée lors de l'étape de première gravure est avantageusement une technique de gravure ionique réactive ou toute autre technique de gravure anisotrope. Ainsi, on contribue à conserver, à l'issue de l'étape de première gravure, la partie du deuxième matériau recouvrant latéralement le premier matériau. La sélectivité de gravure entre le premier matériau et le deuxième matériau n'est pas nécessairement très élevée. Il est tout à fait tolérable de commencer à consommer, pendant la première gravure, le premier matériau déposé.

En revanche, il faut s'assurer qu'on ne grave pas entièrement le premier matériau. La gravure peut donc être réalisée soit au temps, soit en utilisant un système de DFA (Détection de Fin d'Attaque) qui permet de contrôler que la gravure du deuxième matériau déposé est bien complète.

De même, la technique de gravure utilisée lors de l'étape de deuxième gravure est avantageusement une technique de gravure ionique réactive ou toute autre technique de gravure anisotrope. Ainsi, on contribue à conserver, à l'issue de l'étape de deuxième gravure, la partie du premier matériau recouvrant latéralement l'empilement et à maîtriser la côte latérale définissant la longueur de grille mémoire.

Une couche de deuxième matériau d'épaisseur h_{2D} étant déposée lors de l'étape de deuxième dépôt, l'épaisseur h_{2D} est avantageusement telle que : h_{2D} ≥ h₁/n ; h₁ étant l'épaisseur de la couche de premier matériau déposé lors de l'étape de premier dépôt ; le premier matériau se gravant n fois plus vite que le deuxième matériau. En connaissant les vitesses de gravure relatives des deux matériaux et en optimisant les épaisseurs relatives de ces deux matériaux, on s'assure ainsi de ne pas consommer entièrement le deuxième matériau après gravure du premier matériau. L'épaisseur déposée du deuxième matériau sera ainsi suffisante et permettra de ne pas graver le haut du premier matériau lors de l'étape de deuxième gravure.
Avantageusement, l'épaisseur h_{2D} est telle que : h_{2D} ≥ h₁/n + h₁/5. On conserve ainsi, avec une bonne fiabilité, une épaisseur suffisante du deuxième matériau après l'étape de deuxième gravure.

Le premier matériau et le deuxième matériau utilisés sont avantageusement respectivement du polysilicium et du polysilicium-germanium. Le polysilicium peut être gravé sélectivement par rapport au polysilicium-germanium et le polysilicium-germanium peut être gravé sélectivement par rapport au polysilicium.
De façon plus générale, on pourra utiliser comme deuxième matériau du poly-SiGeₓ, x pouvant varier de quelques pourcents à 50%.
Egalement, le poly-SiGeₓ pourra être utilisé en premier matériau et le polysilicium en deuxième matériau.
L'invention concerne également une cellule mémoire électronique comportant :
- un substrat ;
- une première structure de grille déposée sur le substrat, la première structure de grille présentant au moins un flanc latéral ;
- un empilement comprenant plusieurs couches et dont au moins une desdites couches est apte à stocker des charges électriques, ledit empilement recouvrant au moins le flanc latéral de la première structure de grille et une partie du substrat ;
- une deuxième structure de grille isolée de la première structure de grille et du substrat par l'empilement ;
ladite deuxième structure de grille comportant :
- une première région formée d'un premier matériau de grille ;
- une deuxième région formée d'un deuxième matériau de grille, ledit premier matériau de grille pouvant être gravé sélectivement par rapport au dit deuxième matériau de grille et ledit deuxième matériau de grille pouvant être gravé sélectivement par rapport au dit premier matériau de grille ;
- une première zone de siliciuration s'étendant sur ladite première région de la deuxième structure de grille ;
- une deuxième zone de siliciuration s'étendant sur ladite deuxième région de la deuxième structure de grille.

Outre les caractéristiques évoquées dans le paragraphe précédent, la cellule mémoire électronique selon l'invention peut présenter une ou plusieurs caractéristiques complémentaires parmi les suivantes, considérées individuellement ou selon toutes les combinaisons techniquement possibles :
- La première zone de siliciuration et la deuxième zone de siliciuration forment une région continue de siliciuration. On entend par « région continue » le fait que la première zone de siliciuration et la deuxième zone de siliciuration sont alignées et ne présentent aucune différence de marche.
- La première région de la deuxième structure de grille présente un décrochement, dans lequel se situe la deuxième région de la deuxième structure de grille. On entend par « décrochement » une rupture en deux régions dont l'une est en retrait par rapport à l'autre.

D'autres caractéristiques et avantages du procédé selon l'invention ressortiront à la lecture de la description qui suit, en référence aux figures annexées.

### BREVE DESCRIPTION DES FIGURES

Les figures sont présentées à titre indicatif et nullement limitatif de l'invention.
- La figure 1 représente schématiquement un premier exemple de mémoire à double grille selon l'état de la technique combinant la structure d'une mémoire de type NROM avec une architecture split-gate ;
- La figure 2 représente schématiquement un second exemple de mémoire à double grille selon l'état de la technique combinant la structure d'une mémoire de type NROM avec une architecture split-gate ;
- La figure 3 représente une cellule mémoire électronique de type NROM avec une architecture split-gate selon un premier mode de réalisation de l'invention ;
- Les figures 4a à 4k illustrent les étapes d'un exemple de procédé de fabrication de la cellule mémoire de la figure 3 ;
- La figure 5 représente une cellule mémoire électronique de type NROM avec une architecture split-gate selon un deuxième mode de réalisation de l'invention ;
- Les figures 6a et 6b illustrent les étapes d'un exemple de procédé de fabrication de la cellule mémoire de la figure 5.

Pour plus de clarté, les éléments identiques ou similaires sont repérés par des signes de référence identiques sur l'ensemble des figures.

### DESCRIPTION DETAILLEE D'AU MOINS UN MODE DE REALISATION DE L'INVENTION

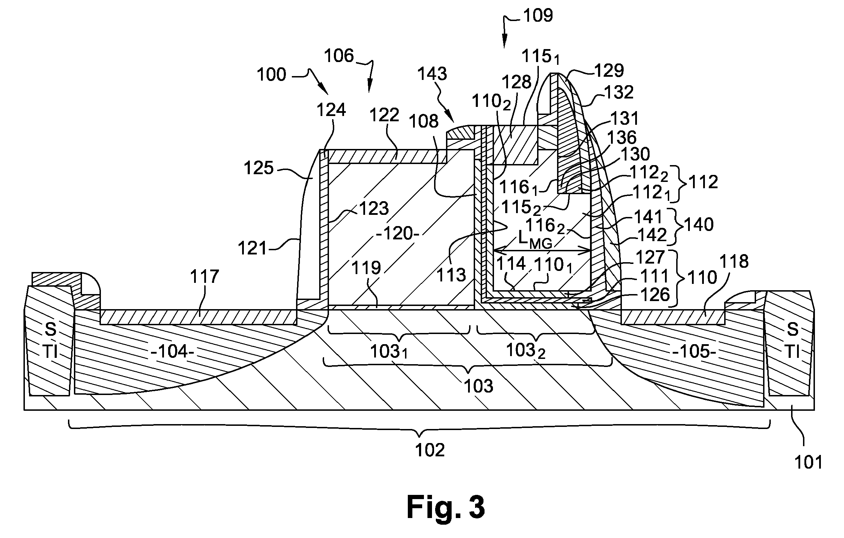

La figure 3 représente une cellule mémoire électronique 100 de type NROM avec une architecture split-gate selon un premier mode de réalisation de l'invention.

La cellule 100 comporte un substrat 101 sur lequel est formée une zone active 102 réalisée dans un matériau semi-conducteur et comportant un canal 103 disposé entre une région d'extension de drain 104 et une région d'extension de source 105. Dans le cas de la réalisation d'un transistor de type n sur un substrat 101 de type p, les régions d'extension de drain 104 et de source 105 sont dopées n+. La région d'extension de drain 104 comporte en outre une siliciuration 117 sur sa surface supérieure. La région d'extension de source 105 comporte en outre une siliciuration 118 sur sa surface supérieure. Le substrat 101 est un substrat à base d'un semiconducteur tel que du silicium. La longueur du canal est ici représentée suivant un axe Ox parallèle au plan du substrat, l'axe Oy étant représenté perpendiculaire au plan du substrat.
Conformément au principe des mémoires de type NROM à architecture split-gate à double grille, la cellule 100 comporte deux structures de grille disposées l'une à côté de l'autre :
- une première structure de grille, dite grille de transistor de sélection (ou grille du transistor de commande) 106 ;
- une seconde structure de grille, dite grille du transistor mémoire (ou grille du transistor de mémorisation) 109 réalisée sous la forme d'un espaceur latéral de la grille du transistor de sélection 106.
Le canal 103 est sensiblement séparé en une première partie 103₁ et une deuxième partie 103₂ côte à côte.
La grille du transistor de sélection 106 surmonte la première partie 103₁ tandis que la grille du transistor de mémorisation 109 surmonte la deuxième partie 103₂.
La grille du transistor de sélection 106 comporte :
- une couche diélectrique de grille 119 (par exemple en SiO₂) au contact de la première partie 103₁ ;
- une zone conductrice 120 de la grille 106 du transistor de sélection (par exemple en polysilicium dopé n+) recouverte par une siliciuration 122.
La grille du transistor de sélection 106 est isolée de la source 105 par la grille 109 du transistor mémoire et du drain 104 par un second espaceur latéral 121.
Plus précisément, la zone conductrice 120 de la grille 106 du transistor de sélection possède une première paroi latérale 108 et une deuxième paroi latérale 123. La première paroi latérale 108 est au contact de la grille 109 du transistor mémoire. La deuxième paroi latérale 123 est entièrement recouverte par le second espaceur latéral 121.
Le second espaceur latéral 121 est un espaceur isolant s'étendant sur tout le flanc latéral (côté drain) et formé d'un matériau diélectrique, qui peut par exemple être un nitrure ou une bicouche oxyde/nitrure (par exemple, une couche 124 de SiO₂ HTO et une couche 125 de Si₃N₄).
La grille 109 du transistor mémoire comporte un empilement 110, par exemple un empilement tri-couches d'oxyde-nitrure-oxyde (dit ONO) formé d'une première couche 126 composée d'un matériau diélectrique (par exemple en SiO₂), d'une seconde couche 111 réalisée dans un matériau apte à stocker des charges électriques (par exemple composée de Si₃N₄) et d'une troisième couche 127 composée d'un matériau diélectrique (par exemple du SiO₂).
L'empilement ONO 110 présente deux zones :
- une première zone d'empilement 110₁ sensiblement horizontale (i.e. avec une surface parallèle au plan du substrat 101) en contact avec la seconde partie 103₂ ;
- une deuxième zone d'empilement 110₂ sensiblement verticale (i.e. avec une surface perpendiculaire au plan du substrat 101).
La grille du transistor mémoire 109 inclut ledit empilement ONO 110 ainsi qu'une zone conductrice de grille du transistor mémoire 112 (par exemple en polysilicium dopé n+).

La zone conductrice 112 de grille du transistor mémoire comporte deux régions :
- une première région 112₁ constituée d'un premier matériau semiconducteur, par exemple du polysilicium, et comportant un décrochement 136 ;
- une deuxième région 112₂ constituée d'un deuxième matériau semiconducteur, par exemple un matériau à base de polysilicium et de germanium (poly-SiGeₓ), et venant combler le décrochement 136 de la première région 112₁. Le premier matériau est tel qu'il peut être gravé sélectivement par rapport au deuxième matériau et le deuxième matériau est tel qu'il peut être gravé sélectivement par rapport au premier matériau, c'est-à-dire que si l'on grave d'une part le premier matériau avec une certaine technique de gravure et d'autre part le deuxième matériau avec la même technique de gravure, les vitesses de gravure seront différentes.

La région 112₁ de la zone conductrice 112 de grille du transistor mémoire présente :
- une première face latérale 113 au contact de la seconde zone d'empilement 110₂ de sorte que cette dernière sépare le flanc latéral 108 de la grille du transistor de sélection 106 et la première face latérale 113 ;
- une face inférieure 114 sensiblement plane et parallèle au plan du substrat 101 ; cette face inférieure 114 est au contact de la première zone 110₁ d'empilement de sorte que cette dernière est intercalée entre la seconde partie 103₂ du canal 103 et la face inférieure 114 de la région 112₁ ;
- une face supérieure 115₁ sensiblement plane et parallèle au plan du substrat 101 ;
- une deuxième face latérale 116₁ sensiblement plane et perpendiculaire au plan du substrat 101;
- une face intermédiaire 115₂ sensiblement plane et parallèle au plan du substrat 101, la hauteur de la face intermédiaire 115₂ par rapport au plan du substrat 101 étant inférieure à la hauteur de la face supérieure 115₁ par rapport au plan du substrat 101. La face intermédiaire 115₂ forme avec la deuxième face latérale 116₁ le décrochement 136 de la région 112₁ ;
- une troisième face latérale 116₂ sensiblement plane et perpendiculaire au plan du substrat 101.
La première face latérale 113 relie la face inférieure 114 à la première face supérieure 115₁. La deuxième face latérale 116₁ relie la première face supérieure 115₁ à la face intermédiaire 115₂. La troisième face latérale 116₂ relie la face inférieure 114 à la face intermédiaire 115₂.
La zone conductrice 112 de grille du transistor mémoire possède une longueur L_{MG}, dite « longueur de grille mémoire », qui est la longueur de la région 112₁ la plus proche de la seconde partie 103₂ du canal 103, mesurée entre la première face latérale 113 et la troisième face latérale 116₂. Comme la troisième face latérale 116₂ est sensiblement plane et perpendiculaire au plan du substrat 101, la distance entre les première et troisième faces latérales 113 et 116₂ reste constante de la face intermédiaire 115₂ jusqu'à la face inférieure 114, ce qui permet un bon contrôle de la longueur L_{MG}.
Une première zone de siliciuration 128 est par ailleurs réalisée sur la première face supérieure 115₁ par dopage et siliciuration.

La région 112₂ de la zone conductrice de grille du transistor mémoire présente :
- une face inférieure 130 sensiblement plane et parallèle au plan du substrat 101 ; cette face inférieure 130 est au contact de la face intermédiaire 115₂ de la région 112₁ de la zone conductrice de grille du transistor mémoire ;
- une première face latérale 131 sensiblement plane et perpendiculaire au plan du substrat 101 ; cette première face latérale présente une zone au contact de la deuxième face latérale 116₁ de la région 112₁ de la zone conductrice de grille du transistor mémoire.
- une face supérieure 132 courbe, reliant la face inférieure 130 à la première face latérale 131. Cette face supérieure 132 permet, par un profil courbe et donc moins abrupt, plus arrondi, de faciliter la reprise de contact ultérieure.
Une deuxième zone de siliciuration 129 est réalisée sur la face supérieure 132 courbe par dopage et siliciuration. La face supérieure 132 de la région 112₂ et la troisième face latérale 116₂ de la région 112₁ forment une surface sensiblement continue.
La cellule 100 selon l'invention utilise donc avantageusement les deux régions 112₁ et 112₂ de la zone conductrice de grille 112 du transistor mémoire afin que la surface totale disponible pour réaliser le contact soit plus importante.

Un espaceur isolant 140, formé d'un matériau diélectrique, qui peut par exemple être un nitrure ou une bicouche oxyde/nitrure (par exemple, une couche 141 de SiO₂ et une couche 142 de Si₃N₄), recouvre toute la surface sensiblement continue formée par la face supérieure 132 de la région 112₂ et la troisième face latérale 116₂ de la région 112₁, exceptée la deuxième zone de siliciuration 129.
On notera également que, dans l'exemple représenté à la figure 3, le flanc latéral de la première zone de siliciuration 128 est également recouvert d'un espaceur isolant 143. L'espaceur isolant 143 est du côté de la grille 106 du transistor de sélection si la face supérieure 115₁ est au-dessus du haut de la grille 106 du transistor de sélection, comme dans l'exemple représenté à la figure 3. Si la région 112₁ a été davantage gravée et que la face supérieure 115₁ est en dessous du haut de la grille 106 du transistor de sélection, l'espaceur isolant 143 se trouvera du côté de la grille 109 du transistor mémoire. Cet espaceur isolant 143 peut être, de la même façon que précédemment, un nitrure ou une bicouche oxyde/nitrure. Cet espaceur isolant 143 permet d'isoler les zones de siliciuration 128 et 122 appartenant respectivement à la grille 109 du transistor mémoire et à la grille 106 du transistor de sélection. Cet espaceur isolant 143 n'est pas forcément indispensable car l'empilement de couches 110 isole déjà la grille 106 du transistor de sélection de la grille 109 du transistor mémoire. Cette dernière configuration peut se produire par exemple si le haut de la grille 109 du transistor mémoire est à peu près du même niveau que le haut de la grille 106 du transistor de sélection. Cependant, l'espaceur isolant 143 contribue à renforcer l'isolation entre les deux grilles.

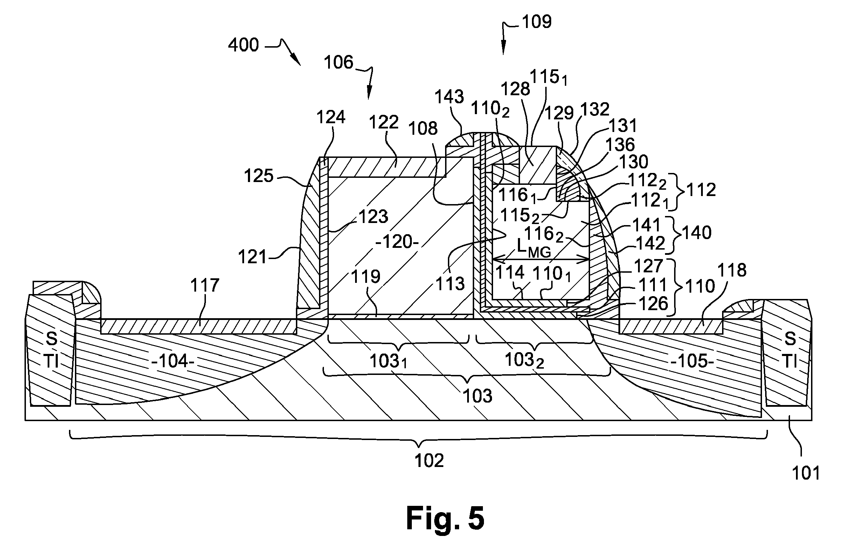

La figure 5 représente une variante 400 de la cellule mémoire électronique de type NROM avec une architecture split-gate de la figure 3. Les cellules 100 et 400 comportent les mêmes caractéristiques, illustrées avec les mêmes références sur la figure 3 et sur la figure 5.
La cellule 400 se différencie de la cellule 100 en ce que la face supérieure courbe 132 de la région 112₂ de deuxième matériau et la face supérieure 115₁ de la région 112₁ de premier matériau forment une surface continue. La face supérieure courbe 132 de la région 112₂ de deuxième matériau assure une transition continue entre la face supérieure 115₁ et la troisième face latérale 116₂ de la région 112₁ de premier matériau. La face latérale 131 de la région 112₂ de deuxième matériau est donc entièrement au contact de la face latérale 116₁ de la région 112₁ de premier matériau. En fonction de la gravure du premier matériau, correspondant à la zone 112₁, la face supérieure 115₁ pourra être plus haute ou moins haute que la grille 106 du transistor de sélection. La face 115₁ peut être au même niveau que le haut de l'empilement 110, comme représenté par exemple sur la figure 3, ou plus bas, comme représenté par exemple sur la figure 5.

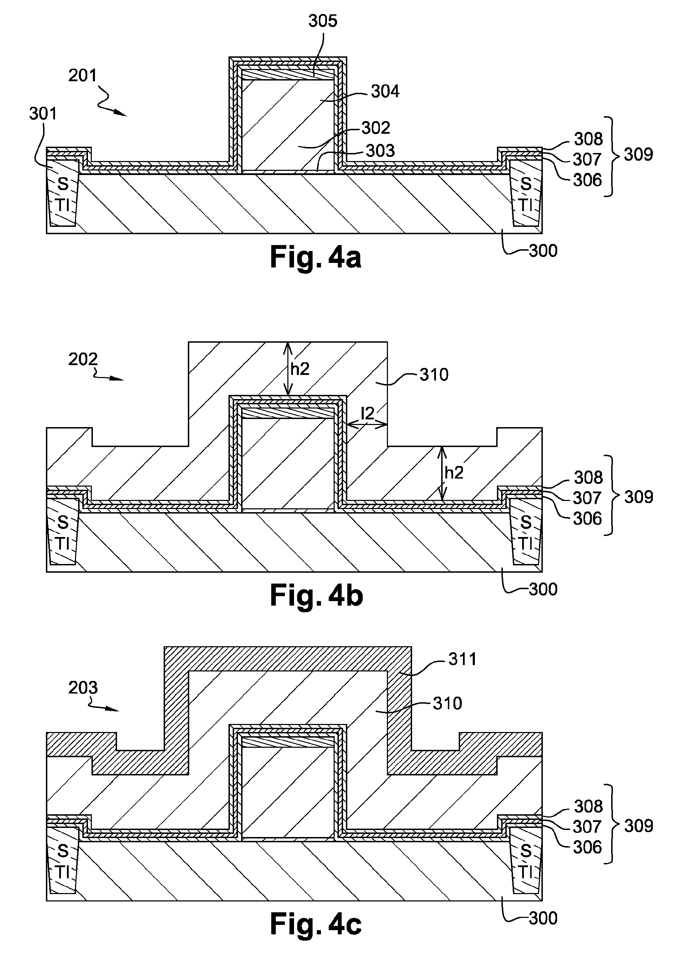

Les figures 4a à 4k illustrent les différentes étapes d'un exemple de procédé de fabrication de la cellule mémoire de la figure 3.
Selon une première étape 201 illustrée en figure 4a, on commence par réaliser dans un substrat 300 (ici substrat silicium) des zones d'isolation 301, par exemple des STI (Shallow Trench Isolation). Puis on réalise, selon un procédé connu de l'homme du métier, une première structure de grille 302, dite grille du transistor de sélection, composée d'une couche diélectrique de grille 303 (réalisée par exemple par oxydation thermique de la zone semi-conductrice formant le substrat) suivie d'une couche conductrice 304 en polysilicium. Une troisième couche diélectrique sacrificielle 305, par exemple du SiO₂, peut être déposée sur la couche conductrice 304. Cette couche sacrificielle 305 est ultérieurement consommée, permettant ainsi d'abaisser le niveau de la première structure de grille 302 et de minimiser ainsi le risque de court-circuit entre la première structure de grille et la deuxième structure de grille.

On réalise ensuite le dépôt d'un empilement tri-couches 309, par exemple de l'oxyde-nitrure-oxyde (dit ONO) formé d'une première couche diélectrique 306 (par exemple en SiO₂), d'une seconde couche 307 réalisée dans un matériau apte à stocker les charges électriques (par exemple composée de Si₃N₄) et d'une troisième couche 308 composée d'un matériau diélectrique (par exemple du SiO₂). Ce dépôt est réalisé de manière à recouvrir la première structure de grille 302. Ce dépôt est avantageusement un dépôt conforme.

Selon une deuxième étape 202 illustrée en figure 4b, on dépose une couche 310 d'un premier matériau de grille du transistor de mémorisation de manière à recouvrir l'empilement 309 précédemment déposé. Le premier matériau peut par exemple être du polysilicium. Le dépôt doit être le plus conforme possible. On entend par « dépôt conforme » un dépôt recouvrant de manière constante le relief sur lequel il est déposé. Dans le cas présent, le dépôt possède une épaisseur h2 mesurée suivant une direction perpendiculaire au plan de référence du substrat, et une épaisseur 12 mesurée suivant une direction perpendiculaire au plan défini par le flan latéral de la deuxième structure de grille. h2 doit donc être le plus proche possible de 12. Par exemple, le ratio I2/h2 est entre 0,8 et 1, et idéalement à 1. Pour assurer une bonne conformité du dépôt, une technique de dépôt chimique en phase vapeur réalisé à pression sous-atmosphérique (Low-pressure chemical vapor déposition en anglais) peut être utilisée.

Selon une troisième étape 203 illustrée en figure 4c, on réalise un dépôt conforme d'épaisseur suffisante d'une couche 311 d'un deuxième matériau de grille du transistor de mémorisation. Nous reviendrons sur la notion d' « épaisseur suffisante » dans la suite du document. Le premier matériau et le deuxième matériau sont tels que, selon les paramètres de gravure :
- le deuxième matériau peut être gravé sélectivement par rapport au premier matériau avec un ratio de vitesses de gravure suffisamment élevé, préférentiellement supérieur ou égal à 2 ;
- le premier matériau peut être gravé sélectivement par rapport au deuxième matériau avec un ratio de vitesses de gravure suffisamment élevé, préférentiellement supérieur ou égal à 2.
On entend par « gravure sélective d'un premier matériau par rapport à un deuxième matériau » une gravure qui affecte principalement ce premier matériau et qui affecte moins le deuxième matériau. Le deuxième matériau peut par exemple être à base de polysilicium-germanium polySiGe. Avant d'effectuer le dépôt de la couche 311 de deuxième matériau, la surface de la couche 310 de premier matériau est préalablement préparée et nettoyée, par exemple avec de l'acide fluorhydrique HF.

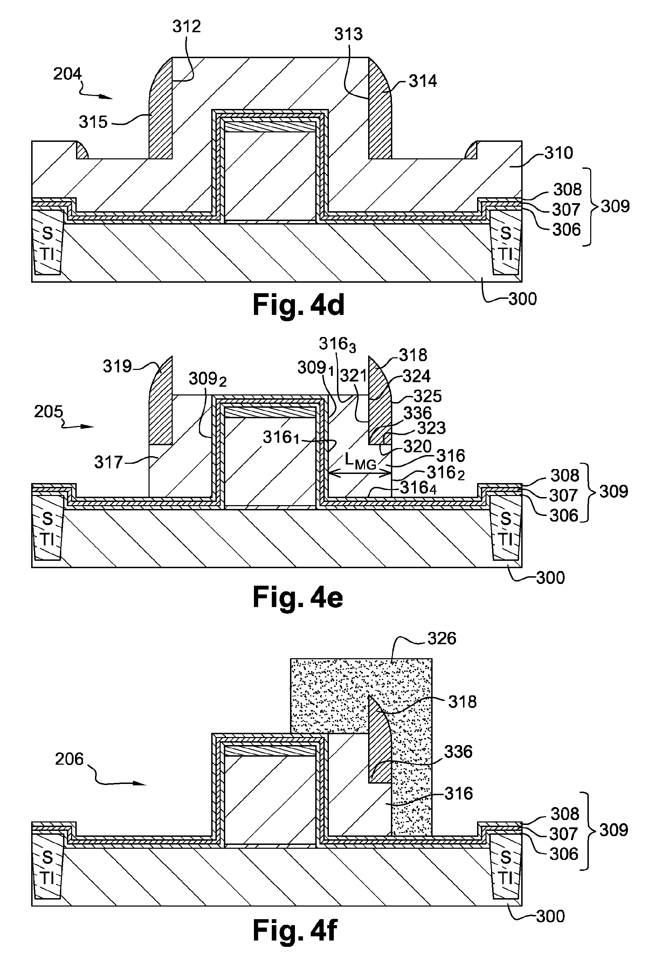

La couche 310 de premier matériau présente notamment un premier flanc latéral 312 et un deuxième flanc latéral 313. Selon une quatrième étape 204 illustrée en figure 4d, l'épaisseur de la couche 311 de deuxième matériau est gravée de manière anisotrope, de façon à conserver le deuxième matériau recouvrant la couche 310 de premier matériau sur ses flancs latéraux 312 et 313. On obtient ainsi une région 314 de deuxième matériau recouvrant le flanc latéral 313 de la couche 310 de premier matériau et une région 315 de deuxième matériau recouvrant le flanc latéral 312 de la couche 310 de premier matériau. Les régions 314 et 315 de deuxième matériau possèdent, du fait de l'étape de gravure anisotrope, un profil extérieur plutôt arrondi. Un tel profil extérieur arrondi est avantageusement mis à profit ultérieurement pour faciliter la reprise de contact en augmentant la surface accessible.
L'arrêt de gravure doit pouvoir être contrôlé : la gravure doit s'arrêter dans le premier matériau et ne pas trop le consommer, d'où l'importance de la sélectivité de gravure du deuxième matériau par rapport au premier matériau. Une technique de gravure ionique réactive (RIE pour Reactive-Ion Etching en anglais) peut être utilisée. La gravure pourra se décomposer en plusieurs étapes, dont une première plus anisotrope et une dernière plus « chimique » (et donc moins anisotrope).

L'empilement 309 présente notamment un premier flanc latéral 309₁ et un deuxième flanc latéral 309₂. Selon une cinquième étape 205 illustrée en figure 4e, l'épaisseur de la couche 310 du premier matériau est gravée :
- de façon la plus anisotrope possible afin d'avoir la surface 316₃ la plus plate possible et ainsi améliorer la reprise de contacts, et la surface 316₂ la plus abrupte possible et ainsi maîtriser la côte latérale et la longueur de grille mémoire L_{MG} associée ;
- sélectivement par rapport au deuxième matériau de façon à contrôler la côte latérale et la longueur de grille mémoire L_{MG} associée ;
- sélectivement par rapport à l'empilement 309, de façon à conserver le premier matériau recouvrant l'empilement 309 sur ses flancs latéraux 309₁ et 309₂. On obtient ainsi une région 316 de premier matériau recouvrant le flanc latéral 309₁ de l'empilement 309 et une région 317 de premier matériau recouvrant le flanc latéral 309₂ de l'empilement 309.
En pratique, la sélectivité de cette étape de gravure n'est pas totale : les régions 314 et 315 de deuxième matériau sont alors un peu gravées et deviennent respectivement la région 318 et la région 319. Les régions 318 et 319 possèdent un profil plus arrondi que les régions 314 et 315, et d'autant plus arrondi qu'elles ont été gravées, facilitant la réalisation ultérieure d'une reprise de contact. Leur cote, c'est-à-dire leur largeur, en est quelque peu modifiée et réduite.

La région 316 de premier matériau est en contact avec la région 318 de deuxième matériau. La région 316 de premier matériau présente en effet un décrochement 336 que vient combler la région 318 de deuxième matériau. La région 317 de premier matériau est en contact avec la région 319 de deuxième matériau. La région 317 de premier matériau présente en effet un décrochement que vient combler la région 319 de deuxième matériau. Les régions 317 et 319 forment une zone inutile et seront éliminées lors d'une étape ultérieure. Les régions 316 et 318 forment en revanche une zone utile et seront conservées par la suite.
La région 316 de premier matériau comporte :
- une face 320 sensiblement plane et parallèle au plan du substrat ;
- une face 321 sensiblement plane et perpendiculaire au plan du substrat. La face 320 et la face 321 forment le décrochement 336.
- une première face latérale 316₁, sensiblement plane et perpendiculaire au plan du substrat, au contact du premier flanc latéral 309₁ de l'empilement 309 ;
- une deuxième face latérale 316₂, sensiblement plane et perpendiculaire au plan du substrat. La longueur L_{MG} sépare la deuxième face latérale 316₂ de la première face latérale 316₁.
- une face supérieure 316₃, sensiblement plane et parallèle au plan du substrat ;
- une face inférieure 316₄, sensiblement plane et parallèle au plan du substrat et au contact de l'empilement 309.
La région 318 de deuxième matériau présente :
- une face inférieure 323 en contact avec la face 320 du décrochement 336 de la région 316 de premier matériau ;
- une première face latérale 324 comprenant au moins une zone en contact avec la face 321 du décrochement 336 de la région 316 de premier matériau ;
- une face supérieure 325 reliant la face inférieure 323 à la première face latérale 324. La face supérieure 325 possède un profil courbe et donc moins abrupt, plus arrondi, qui permet de faciliter la reprise de contact ultérieure. La face supérieure 325 de la région 318 de deuxième matériau forme avec la deuxième face latérale 316₂ de la région 316 de premier matériau une surface sensiblement continue.

Une technique de gravure ionique réactive (RIE pour Reactive-Ion Etching en anglais) peut être utilisée lors de cette étape 205. La gravure de l'épaisseur de la couche 310 du premier matériau doit être sélective par rapport au deuxième matériau. On entend par « gravure sélective d'un premier matériau par rapport à un deuxième matériau » une gravure qui affecte principalement ce premier matériau et qui affecte moins le deuxième matériau.
La région 318 de deuxième matériau ne doit pas être trop gravée car :
- La région 318 de deuxième matériau est avantageusement utilisée pour augmenter la surface de contact et faciliter la reprise de contact ultérieure.
- En outre, la région 318 de deuxième matériau est avantageusement utilisée pour protéger, lors de l'étape de gravure de l'épaisseur de la couche 310 de premier matériau, le premier matériau auquel elle est accolée et permettre ainsi l'obtention d'un flanc latéral 316₂ de la région 316 de premier matériau sensiblement perpendiculaire au plan du substrat 100.
Un tel flanc latéral sensiblement perpendiculaire au plan du substrat est très difficile voire impossible à obtenir par gravure directe du premier matériau en l'absence du deuxième matériau. Dans le cas d'une gravure directe du premier matériau en l'absence du deuxième matériau, le flanc latéral obtenu est sensiblement incliné, ce qui entraîne une absence de contrôle de la longueur L_{MG} de la région 316 de premier matériau, c'est-à-dire de la longueur de grille du transistor de mémorisation. Un tel flanc latéral sensiblement perpendiculaire au plan du substrat permet donc de contrôler la longueur de la grille mémoire L_{MG} et ainsi les performances électriques de la mémoire telles que la fenêtre de programmation ou l'énergie consommée.

Néanmoins, la région 318 de deuxième matériau pourra être avantageusement un peu gravée: en effet, lorsque la région 318 de deuxième matériau est un peu gravée, le premier matériau est alors gravé à l'aplomb du deuxième matériau, ce qui induit une diminution de la longueur L_{MG} de la grille du transistor de mémorisation. Ceci permet donc d'améliorer les performances électriques de la mémoire telles que la fenêtre de programmation ou l'énergie consommée.

Nous revenons ici sur la notion d' « épaisseur suffisante » de deuxième matériau déposée, évoquée lors de l'étape 203. De manière générale, si le deuxième matériau se grave n fois moins vite que le premier matériau, alors l'épaisseur h_{2g} de deuxième matériau enlevée lors de la gravure du premier matériau vaut : h_{2g} = h₁/n, où h₁ est l'épaisseur du premier matériau déposée puis gravée, et où n est la sélectivité de gravure entre le premier matériau et le deuxième matériau. Pour qu'il reste une épaisseur suffisante du deuxième matériau après la gravure du premier matériau, il faut que l'épaisseur h_{2d} déposée du deuxième matériau respecte l'inégalité suivante : h_{2d} ≥ h₁/n. Afin d'assurer une marge suffisante, l'épaisseur h_{2d} déposée du deuxième matériau respecte préférentiellement l'inégalité suivante : h_{2d} ≥ h₁/n + h₁/5.

Selon une sixième étape 206 illustrée en figure 4f, une résine protectrice 326 (par exemple une résine photosensible) est déposée sur la région utile formée par la région 318 de deuxième matériau et par la région 316 de premier matériau. On retire ensuite la région non utile, constituée de la région 317 de premier matériau et de la région 319 de deuxième matériau, par exemple au moyen d'une gravure RIE. La résine protectrice 326 est alors retirée, par exemple avec un procédé de stripping.

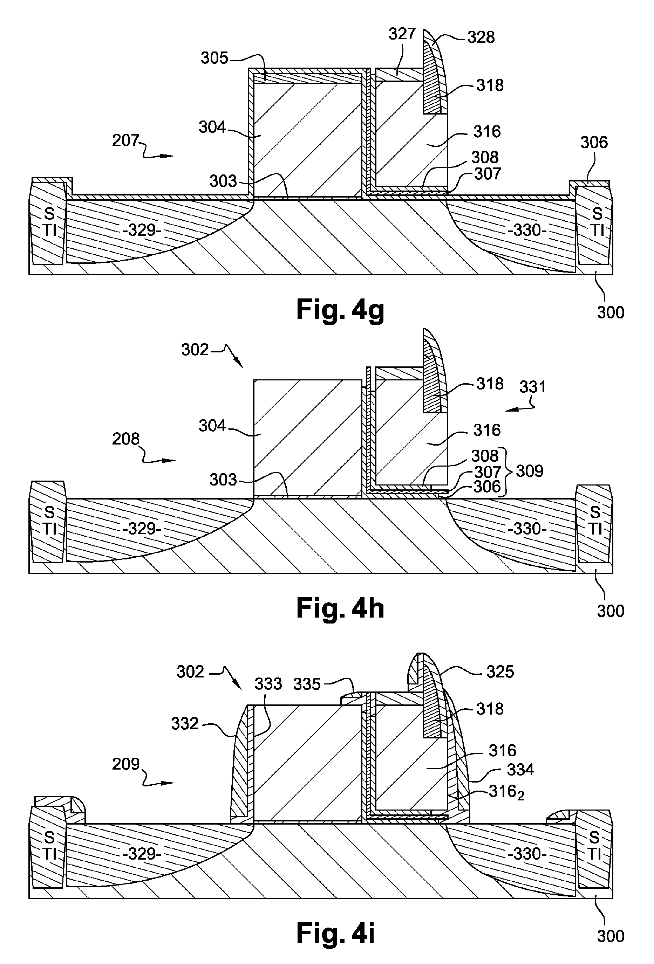

Selon une septième étape 207 illustrée en figure 4g, on réalise le retrait de la troisième couche 308 et de la deuxième couche 307 de l'empilement 309 non recouvert, avec arrêt sur la première couche 306. Dans le cas d'un empilement 309 de type ONO, ce retrait peut être réalisé par gravure anisotrope plasma (gravure sèche) telle qu'une gravure ionique réactive RIE avec arrêt sur la couche de SiO₂ 306. L'étape 207 inclut ensuite une étape d'implantation de manière à commencer le dopage des zones d'extension de source 330 et de drain 329. Ce dopage est un dopage de type LDD (« Low Doped Drain ») permettant de doper à dose moyenne le volume 327 de la région 316, le volume 328 de la région 318 ainsi que les régions d'extension de source 330 et de drain 329. Selon que le transistor que l'on souhaite réaliser est du type PMOS ou NMOS, les ions sont choisis de façon à réaliser des zones d'un type de conductivité p ou n. On notera que pour les régions d'extension de source 330 et de drain 329, l'implantation LDD se fait à travers une partie de la couche 306 qui protège la surface de la zone semi-conductrice du substrat 300 à doper et évite ainsi de détériorer l'état de surface de la zone semi-conductrice. La couche 306 restante sera par la suite éliminée.

Selon une huitième étape 208 illustrée en figure 4h, on réalise le retrait de la couche inférieure 306 de l'empilement ONO 309. Ce retrait est par exemple réalisé par gravure humide isotrope avec une solution partiellement diluée d'acide fluorhydrique (HF) de manière à avoir une bonne sélectivité du retrait de SiO₂ par rapport au substrat 100 (ici substrat silicium). L'empilement 309 résiduel, la région 316 de premier matériau et la région 318 de deuxième matériau forment la deuxième structure de grille 331.
Lorsque, lors de l'étape 201, une couche diélectrique sacrificielle 305 a été déposée sur la couche conductrice 304 de la première structure de grille 302, cette couche 305 est consommée lors de l'étape 208, permettant ainsi d'abaisser le niveau de la première structure de grille 302 et de minimiser ainsi le risque de court-circuit entre la première structure de grille et la deuxième structure de grille. La première structure de grille 302 et la deuxième structure de grille 331 sont déjà isolées entre elles par l'empilement ONO 309. L'abaissement du niveau de la première structure de grille 302 contribue à renforcer cette isolation mais n'est pas obligatoire.

Selon une neuvième étape 209 illustrée en figure 4i, on réalise les différents espaceurs isolants de la cellule mémoire, à savoir :
- un espaceur latéral 332 s'étendant sur tout le flanc latéral 333 de la première structure de grille 302 du transistor de sélection, côté drain ;
- un espaceur isolant 334 s'étendant sur tout le flanc latéral 316₂ de la région 316 et sur une partie de la face supérieure 325 de la région 318 formant la deuxième structure de grille 331 du transistor de mémorisation, côté source ;
- un espaceur isolant 335 s'étendant sur tout le flanc latéral de la deuxième structure de grille 331 du transistor de mémorisation, du côté de la grille du transistor de sélection.
Chacun de ces espaceurs est formé d'un matériau diélectrique, qui peut par exemple être une bicouche oxyde/nitrure (par exemple, une couche de SiO₂ HTO (de l'anglais « High Temperature Oxyde ») et une couche de Si₃N₄).
Pour ce faire, on commence par déposer une première couche d'oxyde dite HTO obtenue par exemple par dépôt LPCVD. Typiquement, une épaisseur de 10 nm est déposée. En tout état de cause, cette épaisseur doit être suffisante pour combler les vides résultant de la gravure isotrope des couches d'oxyde de l'empilement de couches ONO, dans le cas où l'on a utilisé de l'ONO pour assurer la fonction mémoire, intervenue précédemment. Cette couche permet une bonne accroche de la couche de Si₃N₄ déposée par la suite, et remplit également le rôle de couche d'arrêt à la gravure du Si₃N₄.

On réalise ensuite le dépôt d'une autre couche, par exemple une couche de nitrure de silicium (Si₃N₄). Ce dépôt peut être réalisé par la même technique que ci-dessus, c'est-à-dire par dépôt en phase vapeur à basse pression (LPCVD). On dépose une couche de nitrure de silicium qui est typiquement comprise dans une gamme d'épaisseur allant de 20 nm et 40 nm. Cette couche de nitrure de silicium va permettre de former les « espaceurs nitrure » dont le rôle est d' « espacer » les zones d'implantation correspondant aux source/drain, car celles-ci pourraient se rejoindre lors du recuit qui suit l'implantation, notamment dans le cas où les grilles ont de très petites dimensions.
Les espaceurs sont obtenus par gravure de type RIE. On grave de manière anisotrope les couches de matériau isolant précédemment déposées tout en étant le plus sélectif possible par rapport au substrat de silicium. La gravure doit être suffisante pour dégager la partie supérieure des couches surmontant les zones de polysilicium ; ces zones peuvent être siliciurées pour améliorer le contact électrique.

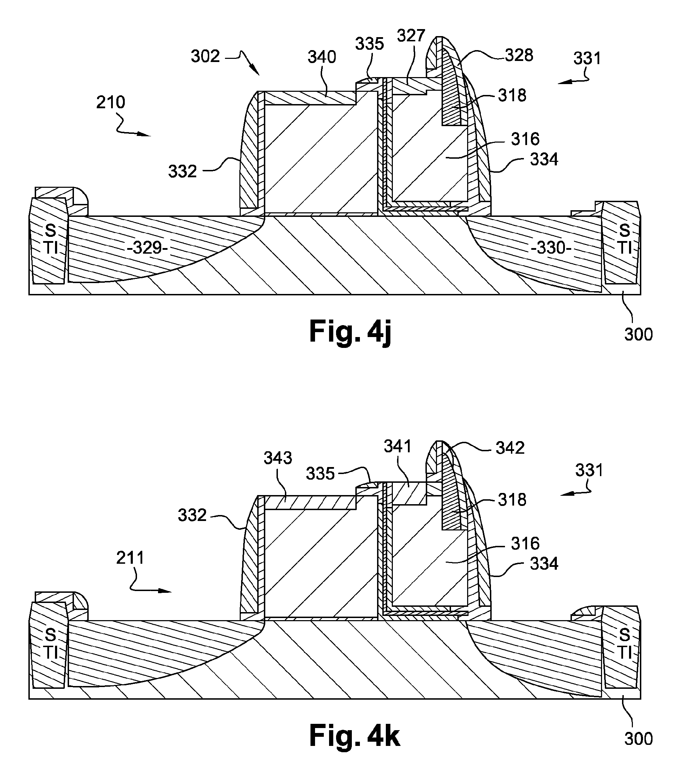

Selon une dixième étape 210 illustrée par la figure 4j, on réalise le dopage à plus forte énergie, approximativement dans l'alignement des espaceurs précédemment fabriqués, de la surface supérieure 327 de la région 316, de la surface supérieure 328 de la région 318, de la surface supérieure 340 de la première structure de grille 302 ainsi que des régions d'extension de source 330 et de drain 329. Cette implantation se rajoute à l'implantation à plus faible énergie LDD (Low Doped Drain) qui est réalisée dans l'alignement des grilles, sauf pour la surface 340 dont c'est, dans l'exemple représenté, le premier dopage (cas où l'on a déposé la couche diélectrique sacrificielle 305 sur la couche conductrice 304). Ce dopage est réalisé par implantation ionique des surfaces 327, 328 et 340 et des régions d'extension de source 330 et de drain 329. Ainsi, dans le cas de la réalisation d'un transistor n-MOS sur un substrat 300 de type p, les surfaces 327, 328 et 340 et les régions d'extension de source 330 et de drain 329 sont dopées n+. Afin d'activer les atomes dopants et de guérir les défauts dus au bombardement, on réalise ensuite un recuit d'implantation (dit également recuit d'activation).

Selon une onzième étape 211 illustrée en figure 4k, on réalise une étape de siliciuration qui correspond à la métallisation des surfaces supérieures 327, 328 et 340 des couches de polysilicium par réaction chimique entre le polysilicium et un métal (par exemple du nickel) de façon à former une zone de faible résistivité. On obtient ainsi une première zone de siliciuration 341 de la première région 316 et une deuxième zone de silicuration 342 de la deuxième région 318. On obtient également une troisième zone de siliciuration 343 de la première structure de grille 302.
Afin de minimiser la résistance des régions d'extension de drain 329 et de source 330 réalisées en silicium monocristallin dopé, on effectue également une étape de siliciuration de ces zones ; la siliciuration correspond à la métallisation de ces zones de drain et de source par réaction chimique entre le silicium et un métal (par exemple du nickel) de façon à former des zones de faible résistivité.

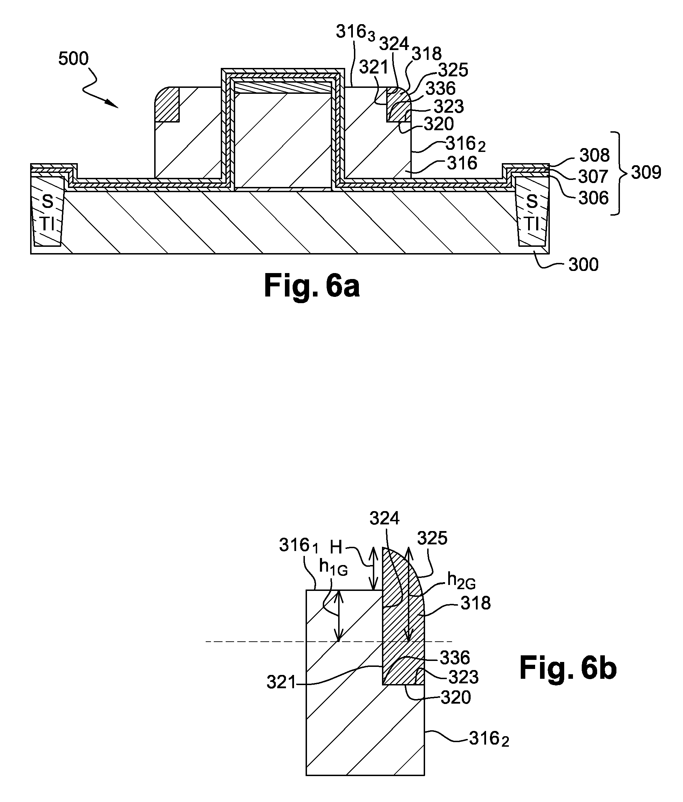

Les figures 6a et 6b illustrent une étape 500 d'un exemple de procédé de fabrication de la cellule mémoire de la figure 5.
Cet exemple de procédé de fabrication de la cellule mémoire de la figure 5 comporte les étapes 201 à 205 communes au procédé illustré aux figures 4a à 4e, puis l'étape 500, illustrée par les figures 6a et 6b.
Selon cette étape 500, on grave le deuxième matériau formant la région 318 de façon à ce que la différence de marche H entre la région 318 de deuxième matériau et la région 316 de premier matériau soit sensiblement réduite à zéro. La surface totale de siliciuration de la face supérieure des régions 316 et 318 est donc augmentée, ce qui améliore la réalisation ultérieure d'une reprise de contact. La face supérieure 325 de la région 318 de deuxième matériau assure une transition continue, sans décrochement, entre la face supérieure 316₃ et la deuxième face latérale 316₂ de la région 316 de premier matériau.
Pour ce faire, il faut que l'épaisseur h_{2G} de deuxième matériau gravée durant cette étape 500 soit telle que : h_{2G} = H + h_{1G}, où H est la différence de marche entre la région 318 et la région 316 et où h_{1G} est l'épaisseur de premier matériau gravée durant l'étape 500. Or, v₁ = h_{1G} / t_{gravure} et v₂ = h_{2G} / t_{gravure}, où v₁ est la vitesse de gravure du premier matériau, v₂ est la vitesse de gravure du deuxième matériau et où t_{gravure} est le temps de gravure de l'étape 500. Donc : v₂ * t_{gravure} = H + v₁ * t_{gravure}. Si on se place dans les conditions de gravure où v₂ = n * v₁, n étant la sélectivité de gravure entre le premier matériau et le deuxième matériau, c'est-à-dire que la gravure est n fois plus rapide pour le deuxième matériau que pour le premier matériau), on obtient : n * v₁ * t_{gravure} = H + v₁ * t_{gravure} donc t_{gravure} = H / [v₁ * (n-1)]. Dans le cas particulier où n = 2, on obtient : t_{gravure} = H / v₁. En fonction des chimies de gravure utilisées et donc des vitesses relatives de gravure des deux matériaux, nous pouvons donc arriver, en ajustant au mieux le temps de gravure, à une configuration où la différence de marche initiale H est réduite à zéro.

Après cette étape 500, cet exemple de procédé de fabrication de la cellule mémoire de la figure 5 comporte les étapes 206 à 211 communes au procédé illustré aux figures 4f à 4k.

Naturellement, l'invention n'est pas limitée aux modes de réalisation décrits en référence aux figures et des variantes peuvent être envisagées sans sortir du cadre de l'invention.

Ainsi, même si l'invention a été plus particulièrement décrite dans le cas d'un premier matériau en polysilicium et d'un deuxième matériau à base de SiGe, il est entendu que l'invention s'applique à d'autres couples de matériaux. De façon plus générale, on parlera d'un matériau en polysilicium et d'un matériau en poly-SiGeₓ, x variant de quelques pourcents à 50%, le premier matériau pouvant être soit en polysilicium, soit en poly-SiGeₓ. Deux conditions sont requises :
- pouvoir réaliser un dépôt du deuxième matériau sur le premier matériau, ce qui sous-entend d'avoir un bon état de surface avant le dépôt du deuxième matériau et d'avoir un paramètre de maille du deuxième matériau compatible avec le paramètre de maille du premier matériau ;
- avoir des vitesses de gravure des deux matériaux suffisamment différentes, par exemple un facteur 2.

L'invention a été plus spécifiquement décrite dans le cas d'un empilement de type ONO mais l'invention s'applique également à tout type de mémoire à couche de piégeage discrète sur architecture split-gate, les électrons pouvant être stockés dans une couche de nitrure (ONO) mais aussi dans une couche en nanocristaux.

De même, les modes de réalisation décrits concernaient des couches diélectriques de grille de type SiO₂ ou SiO₂ HTO mais il est entendu que d'autres types de diélectriques peuvent être utilisés, par exemple des diélectriques de type « high-k » tels que du Al₂O₃ en contact avec la région conductrice de la grille de mémorisation ou une combinaison de couches SiO₂ et de matériaux high K. On entend par matériau high-k ou matériau diélectrique à forte constante diélectrique un matériau ayant une constante diélectrique k strictement supérieure à 3,9 (constante diélectrique du dioxyde de silicium). En particulier dans le cas d'une utilisation d'un matériau diélectrique high-k, il est également possible de remplacer le matériau conducteur en polysilicium des zones conductrices de grille par des matériaux métalliques ou une combinaison de matériaux métalliques et de polysilicium, comme du TiN ou du Si, afin de diminuer le travail de sortie.

## Revendications

1. Procédé (200) de fabrication d'une cellule mémoire électronique comportant :
- un substrat (101, 300) ;
- une première structure de grille (106, 302) déposée sur le substrat ;
- un empilement (110, 309) comprenant plusieurs couches et dont au moins une desdites couches est apte à stocker des charges électriques, ledit empilement recouvrant au moins un flanc latéral (108) de la première structure de grille et une partie du substrat ;
- une deuxième structure de grille (109, 331) isolée de la première structure de grille et du substrat par l'empilement ;
ledit procédé (200) étant **caractérisé en ce que** la formation de la deuxième structure de grille (109, 331) comporte les étapes suivantes :
- dépôt (202) d'une couche (310) d'un premier matériau de la deuxième structure de grille, dit « premier dépôt », au moins sur la zone recouverte par l'empilement (110, 309) ;
- dépôt (203) d'une couche (311) d'un deuxième matériau de la deuxième structure de grille, dit « deuxième dépôt », au moins sur la zone recouverte par la couche (310) de premier matériau, ledit deuxième matériau pouvant être gravé sélectivement par rapport au dit premier matériau et ledit premier matériau pouvant être gravé sélectivement par rapport au dit deuxième matériau ;
- gravure (204) de l'épaisseur de la couche (311) de deuxième matériau, dite « première gravure », sélectivement par rapport au premier matériau de façon à conserver la partie du deuxième matériau recouvrant latéralement le premier matériau ;
- gravure (205) de l'épaisseur de la couche (310) de premier matériau, dite « deuxième gravure », sélectivement par rapport au deuxième matériau de façon à conserver la partie du premier matériau recouvrant latéralement l'empilement, la deuxième structure de grille (109, 331) comportant ainsi ladite partie du premier matériau recouvrant latéralement l'empilement, dite « première région » (112₁, 316) et au moins une partie de ladite partie du deuxième matériau recouvrant latéralement le premier matériau, dite « deuxième région » (112₂, 318) ;
- siliciuration d'une première zone (128, 341) s'étendant sur ladite première région (112₁, 316) de la deuxième structure de grille, et d'une deuxième zone (129, 342) s'étendant sur ladite deuxième région (112₂, 318) de la deuxième structure de grille.

2. Procédé selon la revendication précédente dans lequel le premier matériau présente une face supérieure (115₁, 316₃) et le deuxième matériau présente une face supérieure (132, 325) **caractérisé en ce que** la formation de la deuxième structure de grille comporte en outre, postérieurement à la deuxième gravure (205), une étape (500) suivante :
- gravure du deuxième matériau sélectivement par rapport au premier matériau de telle sorte que la face supérieure (132, 325) du deuxième matériau et la face supérieure (115₁, 316₃) du premier matériau sont alignées.

3. Procédé selon l'une des revendications précédentes **caractérisé en ce que** le premier matériau est du polysilicium et le deuxième matériau est du polysilicium-germanium poly-SiGeₓ.

4. Procédé selon l'une quelconque des revendications 1 ou 2 **caractérisé en ce que** le premier matériau est du polysilicium-germanium poly-SiGeₓ et le deuxième matériau est du polysilicium.

5. Procédé selon la revendication précédente **caractérisé en ce que** le premier matériau est, préalablement au deuxième dépôt (203), nettoyé avec de l'acide fluorhydrique HF.

6. Procédé selon l'une des revendications précédentes **caractérisé en ce qu'**au moins un desdits premier dépôt (202) du premier matériau et deuxième dépôt (203) du deuxième matériau est un dépôt conforme.

7. Procédé selon l'une des revendications précédentes **caractérisé en ce que** le premier dépôt (202) est un dépôt chimique en phase vapeur réalisé à pression sous-atmosphérique.

8. Procédé selon l'une des revendications précédentes **caractérisé en ce que** la technique de gravure utilisée lors de la première gravure (204) et/ou lors de la deuxième gravure (205) est une technique de gravure ionique réactive.

9. Procédé selon l'une des revendications précédentes **caractérisé en ce que** l'épaisseur h_{2D} de la couche (311) de deuxième matériau déposée lors du deuxième dépôt (203) est telle que : h_{2D} ≥ h₁/n ; h₁ étant l'épaisseur de la couche (310) de premier matériau déposée lors du premier dépôt (202) ; le premier matériau se gravant n fois plus vite que le deuxième matériau.

10. Procédé selon l'une des revendications précédentes **caractérisé en ce que** l'épaisseur h_{2D} de la couche (311) de deuxième matériau déposée lors du deuxième dépôt (203) est telle que : h_{2D} ≥ h₁/n + h₁/5 ; h₁ étant l'épaisseur de la couche (310) de premier matériau déposée lors du premier dépôt (202) ; le premier matériau se gravant n fois plus vite que le deuxième matériau.

11. Cellule mémoire électronique (100, 400) comportant :
- un substrat (101, 300) ;
- une première structure de grille (106, 302) déposée sur le substrat, la première structure de grille présentant au moins un flanc latéral (108) ;
- un empilement (110, 309) comprenant plusieurs couches et dont au moins une desdites couches est apte à stocker des charges électriques, ledit empilement recouvrant au moins le flanc latéral de la première structure de grille et une partie du substrat ;
- une deuxième structure de grille (109, 331) isolée de la première structure de grille et du substrat par l'empilement ;
ladite cellule mémoire électronique (100, 400) étant **caractérisée en ce que** la deuxième structure de grille (109, 331) comporte :
- une première région (112₁, 316) formée d'un premier matériau de grille ;
- une deuxième région (112₂, 318) formée d'un deuxième matériau de grille, ledit premier matériau de grille pouvant être gravé sélectivement par rapport au dit deuxième matériau de grille et ledit deuxième matériau de grille pouvant être gravé sélectivement par rapport au dit premier matériau de grille ;
- une première zone de siliciuration (128, 341) s'étendant sur ladite première région (112₁, 316) de la deuxième structure de grille ;
- une deuxième zone de siliciuration (129, 342) s'étendant sur ladite deuxième région (112₂, 318) de la deuxième structure de grille.

12. Cellule mémoire électronique selon la revendication précédente **caractérisée en ce que** la première zone de siliciuration (128, 341) et la deuxième zone de siliciuration (129, 342) forment une région continue de siliciuration.

13. Cellule mémoire électronique selon l'une des revendications 11 ou 12 **caractérisée en ce que** la première région (112₁, 316) de la deuxième structure de grille présente un décrochement (136, 336) dans lequel se trouve la deuxième région (112₂, 318) de la deuxième structure de grille.
